# EUROPEAN PATENT SPECIFICATION

(11) **EP 4 478 847 B1**
(45) Date of publication and mention of the grant of the patent: **04.11.2026**
(21) Application number: 23179776.2
(22) Date of filing: 16.06.2023
(51) Int. Cl.: H05K 5/00, H05K 9/00, H05K 5/15

(54) **JOINING ELEMENT FOR A HOUSING**
VERBINDUNGSELEMENT FÜR EIN GEHÄUSE
ÉLÉMENT DE LIAISON POUR UN BOÎTIER

(43) Date of publication of application: 18.12.2024
(73) Proprietor: Aptiv Technologies AG, 8200 Schaffhausen (CH)
(72) Inventor: BARUS, Lukasz, Dublin, 2 (IE); MYJAK, Piotr, Dublin, 2 (IE); BUDZIAK, Marcin, Dublin, 2 (IE)
(74) Representative: Lewis Silkin LLP

(56) References cited:
- US-A- 5 513 996
- US-A1- 2005 219 832
- US-A1- 2021 105 917
- US-B2- 6 667 872

## Description

### Introduction

The present disclosure relates to a joining element for a housing, such as required between adjoining parts of an electronic control unit (ECU) housing to provide electromagnetic compatibility (EMC).

### Background

An electronic control unit (ECU) typically comprises a housing for accommodating various electronic devices therewithin, such as a processor chip on a printed circuit board (PCB) and associated wiring between components/devices. The housing is often assembled from two die cast halves that must fit together and serve to provide electromagnetic compatibility (EMC) and electrostatic discharge (ESD) mitigation features to meet regulatory requirements.

The corresponding die cast housing parts may be coupled together by complicated and often expensive EMC/ESD protection solutions, such as gaskets made from polymer having embedded metal elements, in combination with screw fasteners to hold the parts together. A particular consideration is the need to compensate for gaps between contacting edges of the housing parts, which vary depending on the manufacturing tolerances. Examples of prior published joining elements include: US5513996, US6667872, US2005219832 and US2021105917.

### Summary

The present disclosure seeks to address issues with fitting housing parts together, e.g. while maintaining EMC/ESD protection. At the least, the disclosure herein provides an alternative option for a joining element incorporated into an ECU housing.

According to a first aspect, a joining element is provided according to claim 1. In an exemplary form, the invention entails a resiliently biased joining element, or spring-clip, comprising a first pair of resilient engagement elements or jaws for receiving a first part to be joined; and a second pair of resilient engagement elements or jaws for receiving a second part to be joined to the first part. The configuration is such that the first pair of engagement elements receives and engages with the first part of the housing by a first engagement force, and the second pair of engagement elements receives and engages with the second part of the housing by a second engagement force. In one form, securing the second part by the second pair of engagement elements causes an increase in the force of the first engagement force on the first part. In this way, the engagement forces, determined by the resilient bias of respective pairs of elements, couple the two parts and the gripping force of the first pair of elements is naturally increased by engagement of the second part into the second pair of elements. Likewise, the engagement force of the first pair, against the resilient bias, influences the second engagement force.

In embodiments, the first and second pair of jaws extend from opposite sides of the joining element, e.g. from a common wall or platform forming a backbone of the element. In this way, if the first and second jaws are aligned, so too can first and second parts at a joining seam. However, alternative solutions are possible, where the jaws are offset to accommodate intentionally offset adjoining parts.

In general, the backbone forms a longitudinal axis about which the respective pairs of jaws pivot.

In embodiments, one or both of the resilient jaws/engagement features may include an opening profile that guides the first and second parts respectively to be received thereinto. In other words, a self-positioning feature which may urge proximate edges of the parts into alignment. In this way, the joining element is in the form of an EMC spring able to self-position and compensate any variation in gap found when connecting two halves of a housing. EMC/ESD protection of unit is thereby improved with less restrictive tolerances for parts since the corresponding edges are hidden within the spring clip/engagement features, allowing for gaps/variations to be accommodated.

In embodiments, the joining element is formed from a sheet of material, bent into a continuous shape. In one embodiment, the sheet is formed at a first edge with a first jaw of the first pair of resilient jaws, bent forwardly to form a first jaw of the second pair of resilient jaws, bent backwardly to form a landing/platform/bridge/backbone portion approximately perpendicular to the jaws for, in use, abutting against or proximate an edge of at least one of the parts to be joined, the sheet further bent backwardly to form a second jaw of the second pair of resilient jaws approximately perpendicular to the landing, further bent forwardly to form a second jaw of the first pair of resilient jaws, corresponding to and terminating at a second edge of the sheet. The first pair of jaws may also include an outward bend to form a constriction area for engaging with/gripping the first part to be joined.

In this way, the first and second jaws are generally aligned and have a pair of common upstanding walls separate by the backbone. The second pair of jaws may have a different, e.g. less, depth than the first pair of jaws, although the depth may be the same or greater. The configuration may generally be described as M-shaped, albeit where the central v point of the M is flattened. Alternatively, the profile can be described wherein a closed end of the first pair of resilient elements, opposite an open end that receives and engage with the first part of the housing, forms a U-shaped portion of the unitary profile that comprises the second pair of engagement elements.

In embodiments, the unitary profile is made from sheet material, e.g. spring steel, formed as a continuous spring clip shape, comprising the first and second engagement features/resilient jaws and backbone/common wall therebetween for, in use, abutting against or proximate to an edge of the parts to be joined. The spring may be formed, e.g. by multiple steps of a rolling machine or stamped by multiple steps in a stamping machine, from initial bends and positioning of sheet up to final shape corresponding to an M is formed.

A second broad aspect of the disclosure according to claim 7 recognises a housing for an ECU. The housing may comprise a cover and a base part, each with upstanding walls configured to face each other at aligning edges and form an enclosure within the housing. Further, the respective upstanding walls of the cover and base part are joined across at least a portion of the respective edges by a joining element according to the first aspect. In embodiments, the joining element provides an engagement/holding function securing between adjoining edges, and optionally further secured by fastening elements through aligned openings of the cover and base part.

In this way, a housing is provided with integral EMC/ESD protection at the seams/joining surfaces of the cover and base part. The housing may comprise a plurality of joining elements accommodated at respective edges of the upstanding walls.

According to a third aspect, a method of assembly is provided according to claim 11. A housing according to the second aspect is assembled by engaging the first pair of jaws of at least one joining element onto an exposed edge of the upstanding wall of either the cover or base part, aligning and engaging an exposed edge of the upstanding wall of the other of the cover or base part with the second pair of jaws of the joining element, applying force to open the second pair of jaws, thereby joining edges of the cover and base part. There may be a plurality of joining elements engaged at an edge via respective first jaws, prior to aligning and engaging respective second jaws of the second part. In a further step, a fastening element is engaged to fix the cover and base parts together, thereby sandwiching joining elements therebetween the edges.

In this way, the joining elements assist to provide a closed housing e.g. that may provide solids or liquid resistance at the seams in addition to an environmental shield. The assembly process eliminates the need for a gasket across at least portions of the joining edge, thereby reducing the bill of materials. The preferred form of (stainless) spring steel, that is not plastically deformable, can achieve small cross sections but where stress can be very high.

According to the foregoing, the problem of complicated and often expensive EMC/ESD protection solutions for corresponding die cast housing parts is solved by an EMC longitudinal spring that allows closure of opening lines between housing parts while, at the same time, reducing costs by relaxing tolerances.

The spring clip style joining element described herein closes longitudinal openings between the housing parts with a self-adapting and self-positioning M-shaped configuration. It positions itself for attachment to both housing parts, firmly connecting them and allowing a gap therebetween to vary due to protruding (jaw) features that are clutching/engaging to grip from both sides, of parts of the upstanding walls beyond the edge. Even if the gap varies during an assembly process, after initial compression the spring joint is secured so opening will not occur.

Accordingly, the invention is directed to a standardized approach for assembling electronic control units, thus streamlining production and potentially avoiding extra cost for design changes. The solution is a simple structural feature but exemplifies a number of benefits, as mentioned above.

### Brief Description of Drawings

Illustrative embodiments will now be described with reference to the accompanying drawings in which:
Figure 1 illustrates an overview of an electronic control unit, ECU, housing in two separated halves or parts;
Figure 2 illustrates an end view of a joining element during assembly of two parts;
Figure 3 illustrates a perspective overview of a joining element of indeterminate length; and
Figure 4 illustrates an overview of the electronic control unit, ECU, housing in an assembled state.

### Detailed Description

The following description presents exemplary embodiments and, together with the drawings, serves to explain principles of the invention. However, the scope of the invention is not intended to be limited to the precise details of the embodiments or exact adherence with all system features and/or method steps, since variations will be apparent to a skilled person and are deemed also to be covered by the description. Terms for components used herein should be given a broad interpretation that also encompasses equivalent functions and features.

In some cases, several alternative terms (synonyms) for structural, system features have been provided but such terms are not intended to be exhaustive. For the avoidance of doubt, any terms separated by the "/" symbol generally refer to alternative "or" expressions where the terms can be used interchangeably. Descriptive terms should also be given the broadest possible interpretation; e.g. the term "comprising" as used in this specification means "consisting at least in part of" such that interpreting each statement in this specification that includes the term "comprising", features other than that or those prefaced by the term may also be present. Related terms such as "comprise" and "comprises" are to be interpreted in the same manner. Any directional terms such as "vertical", "horizontal", "up", "down", "sideways", "upper" and "lower" are used for convenience of explanation usually with reference to the form shown in illustrations and are not intended to be ultimately limiting if an equivalent function can be achieved with an alternative dimension and/or direction. All directional terms are relative to each other.

The description herein refers to embodiments with particular combinations of steps or features, however, it is envisaged that further combinations and cross-combinations of compatible steps or features between embodiments will be possible. Indeed, isolated features may function independently as an invention from other features and not necessarily require implementation as a complete combination.

It will be understood that the illustrated embodiments show uses only for the purposes of explanation. In practice, the invention may be applied to many different configurations, where the embodiment is straightforward for those skilled in the art to implement.

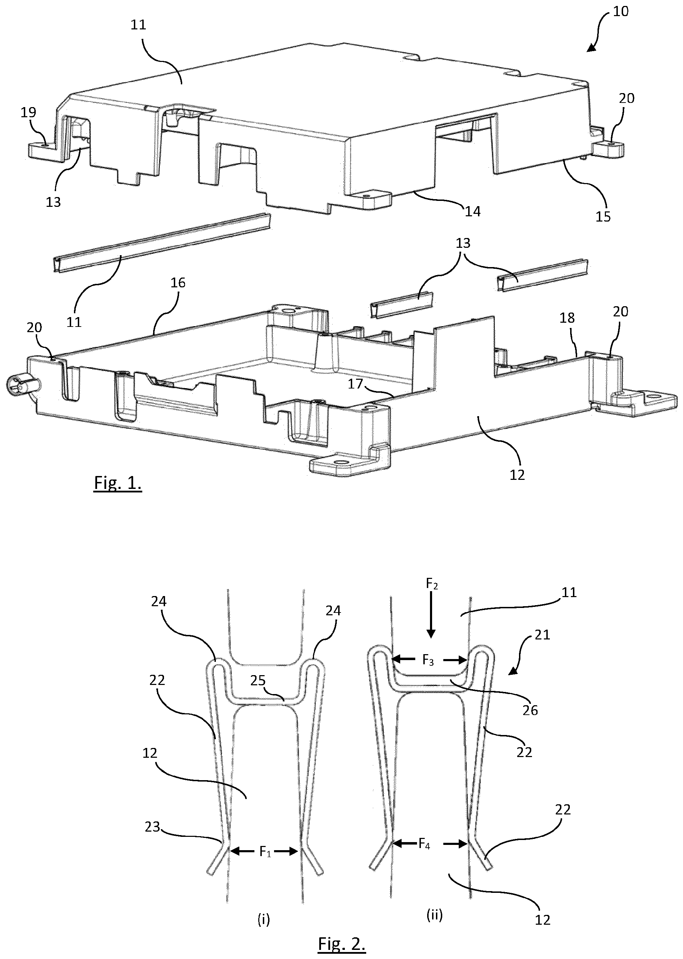

Figure 1 shows an overview of an electronic control unit (ECU) 10 of a type associated with the present invention. Such a unit may be comprised of a housing constructed from two parts, e.g. a cover part 11 and a base part 12, that cooperate to form an enclosure for electronic components within (not shown). Upstanding side walls of each part 11/12 may include matching shapes/cut-out portions and, in general, feature at least one set of corresponding edges to be adjoined, e.g. 13,16; 14,17; 15,18. The two halves may be fixed together by suitable fastening means, such as screws, inserted and tightened into aligning openings 19, 20, e.g. located at corners/protruding flanges of the housing 10.

The housing parts may be made from metal e.g. die casted or stamped (with properly flanged/ended upstanding side walls), which results in variations in terms of the accuracy of dimensions/tolerances.

The invention herein facilitates a method of assembling an electronic control unit 10 as illustrated. Specifically, at least one elongate joining element 21, in the form of a resilient clip, is provided which acts as a means to engage and interface between edges 13, 14, 15 and 16, 17, 18 respectively.

Figure 2 best illustrates an end/section view showing a profile of joining element 21 in relation to parts 11 and 12 during assembly. Particularly, an element 21 includes a first engagement feature, e.g. pair of opposing jaws 22 that are engageable, by downward force onto, or upward force into, lower part 12 at a contact/constricting/engagement portion 23. Jaws 22 are resiliently biased to a narrower state and part 12 can be introduced to a widened opening in jaws 22, upstream of the constriction, forcing them apart against the surface/point 23, as indicated by directional arrows F₁.

At the opposite side of the element 21, proximate and protruding toward upper part 11, a second engagement feature, e.g. pair of opposing jaws 24, is located. The respective jaws 22 and 24 may be connected by a common platform/landing/backbone 25 which is relatively flat and provides a recessed throat, continuous with the upstanding walls of jaws 24.

The assembly state (i) of Figure 2 shows upper part 11 before engagement (lower part 12 is already engaged as outlined above), whereas state (ii) of Figure 2 shows that part 11 has been downwardly forced (F₂) between jaws 24, facilitated by resilience of the element 21 and a guiding profile of the opening to jaws 24. In other words, any misalignment between edges of parts 11 and 12 is corrected by the opening itself. Part 11 is not necessarily forced into full abutment with platform 25 and may appear as in state (ii) in its assembled form or some variation thereof. During engagement of the first pair of jaws 22 (i.e. being forced apart) at state (i), the second pair of jaws 24 are urged toward each other, i.e. to load tension into the second jaws for subsequently engaging a part. At state (ii) second jaws 24 are forced apart against the tension by part 11. This also increases the force on the part 12 by the first pair of elements 22 (at 23). Outward force caused by part 11 is indicated by directional arrows F₃.

By way of example, prior to the state (i) of Figure 2, a downward assembly force to engage the first pair of jaws 22 onto lower part 12 may be approximately 9N, resulting in an outward force F₁ at each jaw 22, constriction point 23, of 12N.

During the second step (ii) of Figures 2, an assembly force F₂ of 450N may generate 620N in each direction (F₃) at the second pair of jaws 24. Furthermore, forcing apart jaws 24 by introduction of part 11 also places additional force on the constriction points 23 of the first jaws 22. In the worked example of (ii), the force in each direction F₄ increases to 40N.

While at state (ii) of Figure 2 the upper 11 and power 12 parts of housing 10 are engaged with and held together by the engagement/jaw features of joining element 21 and forces outlined above, nevertheless, a conventional fastener may still be utilised (through aligned openings 19, 20) to secure the parts 11 and 12 together. In any event, it will be apparent that any space/gap 26 between the parts 11, 12 is shielded by the joining element (e.g. walls of jaws 24) to mitigate ingress of dust, liquid and electromagnetic fields through the join.

The illustrated configuration ensures that adjoining parts are aligned or urged into alignment. Alternative embodiments may feature engagement features/jaws that are intentionally misaligned, to accommodate an intentional design feature of the parts/housing. In this sense, "alignment" used herein means to be guided into an intended relative position.

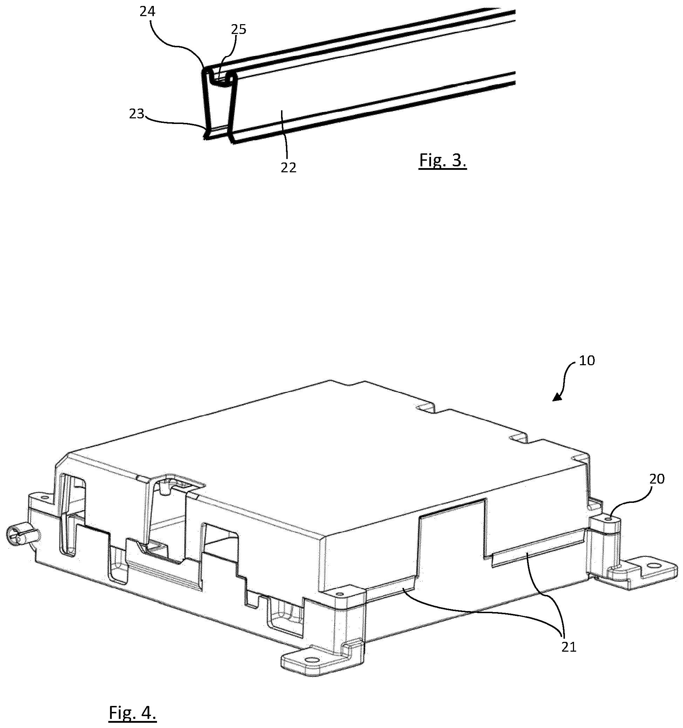

Electronic devices can be assembled into the housing in the normal way, prior to closure by the above method. A complete assembly of housing 10 is illustrated by Figure 4, where elements 21 are visible at the seams of abutting sidewalls 11 and 12. The adjoining edges 13,16; 14,17; 15,18 are effectively hidden from view within clip 21.

A housing as described herein can be constructed from known materials, e.g. die cast metal. The resilient joining element/clip of the invention may be formed from a sheet of spring steel or equivalent material which maintains EMC properties for the ECU as a whole, in order to meet regulatory standards.

By way of summary, the disclosure herein explains the function of a joining element, such as to provide electromagnetic shielding of assembled halves of an electronic control unit. The element, e.g. formed in one elongate and continuous piece from spring steel, comprises a first pair of resilient jaws for receiving a first half of the housing, and a second pair of resilient jaws (24) for receiving a second half of the housing. The jaws position and secure the parts in aligned configuration and bridge any gap/variations in the respective adjoining edges. The element is effectively a clip formed in a continuous generally M-shape from a spring steel sheet material, where the legs of the M form the first pair of resilient jaws and the v part of the M forms the second pair of resilient jaws. Although the point of the v is preferably flattened to serve as a backbone portion along the longitudinal length of the clip.

## Claims

1. A joining element (21) for coupling two parts (11, 12) of an electronic control unit housing (10), comprising:
a first pair of resilient engagement elements (22) for receiving a first part (12) of the housing; and
a second pair of resilient engagement elements (24) for receiving a second part (11) of the housing to be coupled to the first part (12);
wherein the first pair of engagement elements is configured to receive and engage with the first part (12) of the housing by a first engagement force (F₁);
wherein the second pair of engagement elements (24) is configured to receive and engage with the second part of the housing by a second engagement force (F₃);
characterised
wherein the first (22) and second (24) pair of resilient elements are formed as a unitary profile, elongate along a longitudinal axis about which the respective pairs of elements pivot;
wherein a closed end of the first pair (22) of resilient elements, opposite an open end that receives and engages with the first part (12) of the housing, forms a U-shaped portion of the unitary profile that comprises the second pair (24) of engagement elements; and
wherein securing the second part (11) of the housing by the second pair (24) of engagement elements causes an increase in the force (F₄) of the first engagement force on the first part (12).

2. The joining element (21) according to claim 1, formed from an electromagnetically compatible material.

3. The joining element (21) according to claim 1 or 2, wherein the first (22) and second (24) pair of resilient elements extend from opposite directions of a common wall element (24), that is the bottom of the U-shape, for aligning the parts (11, 12) to be coupled.

4. The joining element (21) according to any preceding claim, wherein an opening to either or both pairs (22, 24) of elements includes a guide feature (23) for facilitating positioning of the respective part.

5. The joining element according to any preceding claim, wherein the second pair (24) of elements is less than or equal to the depth of the first pair (22) of elements.

6. The joining element according to any preceding claim, formed from spring steel.

7. A housing (10) comprising:
a first part (12); and
a second part (11);
wherein each of the parts have upstanding walls configured to align with each other at corresponding edges to form an enclosed space within the housing; and
at least one joining element (21) according to any preceding claim, for coupling the respective upstanding walls (12, 11) of the parts across at least a portion of the respective edges.

8. The housing of claim 7, wherein the parts (11, 12) are further secured together by at least one fastening element.

9. The housing of claim 8, wherein the fastening element is a screw extending through aligned openings (19, 20) of the parts (11, 12).

10. The housing of any of claims 7 to 9, wherein the first part (12) and second part (11) are die cast or stamped sheet metal.

11. A method of assembling a housing according to any of claims 7 to 10, comprising the steps of:
a) engaging the first pair (22) of resilient elements of the at least one joining element (21) onto an edge (16) of the upstanding wall of either part;
b) aligning and engaging an edge (13) of the upstanding wall of the other part with the second pair (24) of resilient elements of the joining element; and
c) applying force (F₂) to one or both of the housing parts in a direction toward each other, thereby forcing open the second pair (24) of resilient elements, and increasing the first engagement force (F₄) to couple edges of the first and second part in electrical contact.

12. The method of claim 11, wherein, at step a) there are a plurality of joining elements (21) to be engaged at an edge via respective first pairs of engagement elements.

13. The method according to claim 11 or 12, comprising: d) engaging a further fastening element to secure the housing parts together.

## Patentansprüche

1. Verbindungselement (21) zum Koppeln zweier Teile (11, 12) eines Gehäuses (10) einer elektronischen Steuereinheit, umfassend:
ein erstes Paar elastischer Eingriffselemente (22) zum Aufnehmen eines ersten Teils (12) des Gehäuses; und
ein zweites Paar elastischer Eingriffselemente (24) zum Aufnehmen eines zweiten Teils (11) des Gehäuses, um es mit dem ersten Teil (12) zu koppeln;
wobei das erste Paar von Eingriffselementen so konfiguriert ist, dass es den ersten Teil (12) des Gehäuses aufnimmt und mit diesem über eine erste Eingriffskraft (F₁) in Eingriff steht;
wobei das zweite Paar von Eingriffselementen (24) so konfiguriert ist, dass es den zweiten Teil des Gehäuses aufnimmt und mit diesem über eine zweite Eingriffskraft (F₃) in Eingriff steht;
**gekennzeichnet durch**
wobei das erste (22) und das zweite (24) Paar elastischer Elemente als einstückiges Profil ausgebildet sind, das sich entlang einer Längsachse erstreckt, um die die jeweiligen Paare von Elementen schwenkbar sind;
wobei ein geschlossenes Ende des ersten Paares (22) elastischer Elemente, das einem offenen Ende gegenüberliegt, das den ersten Teil (12) des Gehäuses aufnimmt und mit diesem in Eingriff steht, einen U-förmigen Abschnitt des einstückigen Profils bildet, der das zweite Paar (24) von Eingriffselementen umfasst; und
wobei das Sichern des zweiten Teils (11) des Gehäuses durch das zweite Paar (24) von Eingriffselementen eine Erhöhung der Kraft (F₄) der ersten Eingriffskraft auf den ersten Teil (12) bewirkt.

2. Verbindungselement (21) nach Anspruch 1, das aus einem elektromagnetisch kompatiblen Material besteht.

3. Verbindungselement (21) nach Anspruch 1 oder 2, wobei sich das erste (22) und das zweite (24) Paar elastischer Elemente aus entgegengesetzten Richtungen von einem gemeinsamen Wandelement (24), das den Boden der U-Form bildet, erstrecken, um die zu koppelnden Teile (11, 12) auszurichten.

4. Verbindungselement (21) nach einem der vorhergehenden Ansprüche, wobei eine Öffnung an einem oder beiden Paaren (22, 24) von Elementen ein Führungselement (23) zum Erleichtern der Positionierung des jeweiligen Teils einschließt.

5. Verbindungselement nach einem der vorhergehenden Ansprüche, wobei das zweite Paar (24) von Elementen eine Tiefe aufweist, die kleiner oder gleich der Tiefe des ersten Paares (22) von Elementen ist.

6. Verbindungselement nach einem der vorhergehenden Ansprüche, das aus Federstahl hergestellt ist.

7. Gehäuse (10) umfassend:
ein erstes Teil (12); und
ein zweites Teil (11);
wobei jedes der Teile aufragende Wände aufweist, die so konfiguriert sind, dass sie an entsprechenden Kanten miteinander fluchtend angeordnet zu sein, um innerhalb des Gehäuses einen geschlossenen Raum zu bilden; und
mindestens ein Verbindungselement (21) nach einem der vorhergehenden Ansprüche zum Koppeln der jeweiligen aufragenden Wände (12, 11) der Teile über mindestens einen Abschnitt der jeweiligen Kanten hinweg.

8. Gehäuse nach Anspruch 7, wobei die Teile (11, 12) ferner durch mindestens ein Befestigungselement miteinander verbunden sind.

9. Gehäuse nach Anspruch 8, wobei das Befestigungselement eine Schraube ist, die sich durch fluchtend angeordnete Öffnungen (19, 20) der Teile (11, 12) erstreckt.

10. Gehäuse nach einem der Ansprüche 7 bis 9, wobei der erste Teil (12) und der zweite Teil (11) Druckgussteile oder Stanzblechteile sind.

11. Verfahren zum Zusammenbauen eines Gehäuses nach einem der Ansprüche 7 bis 10, umfassend die Schritte:
a) In-Eingriff-Bringen des ersten Paares (22) elastischer Elemente des mindestens einen Verbindungselements (21) mit einer Kante (16) der aufragenden Wand eines der beiden Teile;
b) Ausrichten und In-Eingriff-Bringen einer Kante (13) der aufragenden Wand des anderen Teils mit dem zweiten Paar (24) elastischer Elemente des Verbindungselements; und
c) Aufbringen einer Kraft (F₂) auf eines oder beide Gehäuseteile in einer Richtung aufeinander zu, wodurch das zweite Paar (24) elastischer Elemente auseinandergedrückt und die erste Eingriffskraft (F₄) erhöht wird, um Kanten des ersten und zweiten Teils in elektrischen Kontakt zu bringen.

12. Verfahren nach Anspruch 11, wobei in Schritt a) eine Vielzahl von Verbindungselementen (21) vorhanden ist, die jeweils über ein erstes Paar von Eingriffselementen mit einer Kante in Eingriff zu bringen sind.

13. Verfahren nach Anspruch 11 oder 12, umfassend:
d) In-Eingriff-Bringen eines weiteren Befestigungselements, um die Gehäuseteile miteinander zu verbinden.

## Revendications

1. Élément de jonction (21) destiné à accoupler deux parties (11, 12) d'un boîtier d'unité de commande électronique (10), comprenant :
une première paire d'éléments d'entrée en prise élastiques (22) destinée à recevoir une première partie (12) du boîtier ; et
une seconde paire d'éléments d'entrée en prise élastiques (24) destinée à recevoir une seconde partie (11) du boîtier devant être accouplée à la première partie (12) ;
dans lequel la première paire d'éléments d'entrée en prise est conçue pour recevoir et entrer en prise avec la première partie (12) du boîtier par une première force d'entrée en prise (F₁) ;
dans lequel la seconde paire d'éléments d'entrée en prise (24) est conçue pour recevoir et entrer en prise avec la seconde partie du boîtier par une seconde force d'entrée en prise (F₃) ;
**caractérisé par**
dans lequel les première (22) et seconde (24) paires d'éléments élastiques sont formées comme un profil d'un seul tenant, allongées le long d'un axe longitudinal autour duquel les paires respectives d'éléments pivotent ;
dans lequel une extrémité fermée de la première paire (22) d'éléments élastiques, opposée à une extrémité ouverte qui reçoit la première partie (12) du boîtier et entre en prise avec celle-ci, forme une portion façonnée en U du profil d'un seul tenant qui comprend la seconde paire (24) d'éléments d'entrée en prise ; et
dans lequel la fixation de la seconde partie (11) du boîtier par la seconde paire (24) d'éléments d'entrée en prise provoque une augmentation de la force (F₄) de la première force d'entrée en prise sur la première partie (12).

2. Élément de jonction (21) selon la revendication 1, formé à partir d'un matériau électromagnétiquement compatible.

3. Élément de jonction (21) selon la revendication 1 ou 2, dans lequel la première paire (22) et la seconde paire (24) d'éléments élastiques s'étendent à partir de directions opposées d'un élément de paroi commune (24), qui est le fond de la forme en U, pour aligner les parties (11, 12) devant être accouplées.

4. Élément de jonction (21) selon une quelconque revendication précédente, dans lequel une ouverture vers l'une ou l'autre ou les deux paires (22, 24) d'éléments comprend une caractéristique de guidage (23) destinée à faciliter le positionnement de la pièce respective.

5. Élément de jonction selon une quelconque revendication précédente, dans lequel la seconde paire (24) d'éléments est inférieure ou égale à la profondeur de la première paire (22) d'éléments.

6. Élément de jonction selon une quelconque revendication précédente, formé à partir d'acier à ressort.

7. Boîtier (10) comprenant :
une première partie (12) ; et
une seconde partie (11) ;
dans lequel chacune des parties présentant des parois verticales conçues pour s'aligner les unes aux autres au niveau des bords correspondants pour former un espace fermé à l'intérieur du boîtier ; et
au moins un élément de jonction (21) selon une quelconque revendication précédente, destiné à accoupler les parois verticales respectives (12, 11) des parties sur toute l'étendue d'au moins une portion des bords respectifs.

8. Boîtier selon la revendication 7, dans lequel les parties (11, 12) sont en outre immobilisées ensemble par au moins un élément de fixation.

9. Boîtier selon la revendication 8, dans lequel l'élément de fixation est une vis s'étendant à travers des ouvertures alignées (19, 20) des parties (11, 12).

10. Boîtier selon l'une quelconque des revendications 7 à 9, dans lequel la première partie (12) et la seconde partie (11) sont en tôle moulée sous pression ou estampée.

11. Procédé d'assemblage d'un boîtier selon l'une quelconque des revendications 7 à 10, comprenant les étapes suivantes :
a) l'entrée en prise de la première paire (22) d'éléments élastiques dudit au moins un élément de jonction (21) sur un bord (16) de la paroi verticale de l'une ou l'autre des parties ;
b) l'alignement et l'entrée en prise d'un bord (13) de la paroi verticale de l'autre partie avec la seconde paire (24) d'éléments élastiques de l'élément de jonction ; et
c) l'application d'une force (F₂) à l'une et/ou l'autre parties du boîtier dans une direction l'une vers l'autre, ce qui permet de forcer la seconde paire (24) d'éléments élastiques à s'ouvrir, et l'augmentation de la première force d'entrée en prise (F₄) pour coupler les bords de la première et de la seconde partie en contact électrique.

12. Procédé selon la revendication 11, dans lequel, à l'étape a), il y a une pluralité d'éléments de jonction (21) devant être mis en prise au niveau d'un bord par l'intermédiaire de premières paires respectives d'éléments d'entrée en prise.

13. Procédé selon la revendication 11 ou 12, comprenant :
d) l'entrée en prise d'un autre élément de fixation pour immobiliser les parties du boîtier ensemble.
